# EUROPÄISCHE PATENTSCHRIFT

(11) **EP 0 563 673 B1**
(45) Veröffentlichungstag und Bekanntmachung des Hinweises auf die Patenterteilung: **28.02.1996**
(21) Anmeldenummer: 93104252.7
(22) Anmeldetag: 16.03.1993
(51) Int. Cl.: H05K 9/00, H01R 13/658

(54) **Federblech zum grossflächigen Kontaktieren zweier Gehäuseteile**
Spring blade for contacting two large-surface casing parts
Plaque ressort pour établir un contact entre deux parties de boîtier de grande surface

(30) Priorität: 31.03.1992 DE 4210634
(43) Veröffentlichungstag der Anmeldung: 06.10.1993
(73) Patentinhaber: SIEMENS AKTIENGESELLSCHAFT, D-80333 München (DE)
(72) Erfinder: Schröcker, Anton, Dipl.-Ing., W-8000 München 60 (DE); Schiefele, Horst, W-8000 München 70 (DE); Voss, Hans, Dipl.-Ing., W-8029 Sauerlach (DE); Wiedemann, Albert, W-8000 München 71 (DE)

(56) Entgegenhaltungen:
- DE-A- 2 348 686
- DE-A- 2 448 421
- DE-A- 3 335 664
- IBM TECHNICAL DISCLOSURE BULLETIN, Bd. 21, Nr. 3, August 1978, New York,US;Seiten 955 - 956 N.C. ARVANITAKIS and J.G. SIMEK:"Ground plane interposer"

## Beschreibung

Die Erfindung bezieht sich auf ein Federblech zum elektrischen Kontaktieren zweier großflächig gegeneinander verspannter Gehäuseteile, wobei das sich über den Kontaktierbereich erstreckende Federblech zwischen die Gehäuseteile einlegbar ist und beidseitig eine Vielzahl von federnd nachgiebigen kontaktgebenden Erhebungen aufweist.

Ein derartiges Federblech ist z.B. durch die Firmenschrift bulletin 27-0027-53 Rev. 4 der Firma Spektrum Control, Inc. bekannt geworden. Danach weist ein metallisches Steckergehäuse einen umlaufenden Kragen auf, der mittels Schrauben an einer Gehäuseplatte eines elektrischen Gerätes befestigbar ist. Um Unregelmäßigkeiten der Montageoberflächen auszugleichen, und dadurch entstehende Spalte elektromagnetisch abzudichten, ist zwischen die Gehäuseteile ein vielfach gewelltes Federblech eingelegt. Dieses wird beim Anschrauben des Steckergehäuses zusammengedrückt. Dabei bilden die kontaktgebenden Erhebungen eine Vielzahl von gleichmäßig verteilten Kontaktstellen, die die Schirmwirkung verbessern. Nachteilig ist dabei, daß sich die Wellen lediglich in einer Koordinatenrichtung entlang der Längsseiten des Steckergehäuses erstrecken und daß somit die Stirnseiten nicht so gut abgedichtet werden können. Ferner streckt sich das Federblech beim Zusammendrücken, wobei sich die entstehenden Reibungskräfte summieren. Diese Reibungskräfte werden um so höher, je größer die Anzahl der Wellen ist. Das bedeutet, daß insbesondere bei großen Steckern die Wellenlänge relativ groß gehalten werden muß, was die Schirmwirkung gefährdet.

Ferner ist durch die DE-A 24 48 421 ein bandförmiger Dichtungsstreifen bekannt geworden, bei dem freigeschnittene Kontakt zungen abwechselnd nach der einen oder anderen Seite ausgebogen sind.

Ferner ist es durch die DE-A 23 48 686 bekannt, in einem Dichtungsband durch Querschlitze kammartig freigeschnittene Zungen zu bilden, die nach beiden Seiten ausgebogen sind, so daß ihre höchsten Stellen in ihrem Kantenbereich liegen. Die freigeschnittenen Zungen, die die kontaktgebenden Erhebungen aufweisen, sind nun federungsmäßig soweit entkoppelt, daß sie sich beim Zusammendrücken gegenseitig nicht beeinflussen. Das Federblech bleibt in seiner Außenabmessung nahezu unverändert und kann somit leichter positioniert werden. Es kommt zu einem scharfkantigen Kontakt zwischen der Zunge und den entsprechenden Gehäuseteilen, so daß es auch bei vorhandenen Oxidschichten oder anderen Verunreinigungen zu einer sicheren Kontaktgabe kommt.

Der Erfindung liegt die Aufgabe zugrunde, die Kontaktgabe und die Schirmwirkung zu verbessern.

Diese Aufgabe wird durch die Erfindung gemäß Anspruch 1 gelöst.

Durch die Erfindung werden bei höheren Federkräften beide Gehäuseteile mit jeder Zungen kontaktiert. Durch den besonders engen Abstand zwischen den Kontaktstellen wird die Schirmwirkung weiter verbessert. Beim Zusammendrücken der Teile verdrehen sich Zungen. Dadurch entstehen Reibungskräfte, die bei in gleicher Richtung verdrehten Zungen zwischen dem Federblech und dem Gehäuse eine Schubkraft erzeugen. Durch die wechselseitige Verdrehung der Zungen werden die beim Zusammendrücken entstehenden Reibungskräfte zwischen jeweils zwei benachbarten Zungen kompensiert, wodurch die Lage des Federblechs unbeeinflußt bleibt.

Durch die Weiterbildung der Erfindung nach Anspruch 2 kann das Federblech zwischen dem Durchbruch und den Federzungen besonders dünn gehalten werden, was eine besonders schmale Bauweise des Steckergehäuses ermöglicht. Durch die Stege wird das Federblech außerdem stabilisiert, was die Handhabung und Montage erleichtert.

Durch die Weiterbildung nach Anspruch 3 kann das Federblech z.B. am Gehäuse des elektrischen Gerätes fixiert werden, bevor das Steckergehäuse aufgesetzt wird, was die Montage erleichtert.

Im folgenden wird die Erfindung anhand eines in der Zeichnung dargestellten Ausführungsbeispiels näher erläutert.
- Figur 1: zeigt eine Draufsicht auf ein Federblech,
- Figur 2: eine Seitenansicht des Federblechs nach Figur 1 mit einem Steckergehäuse und einer Gehäusewand eines elektrischen Gerätes.

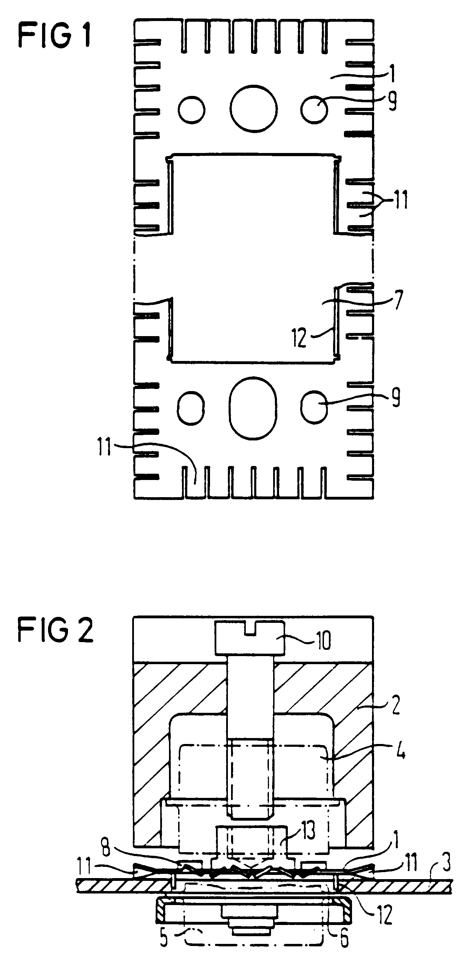

Nach den Figuren 1 und 2 ist ein dünnes Federblech 1 aus geeignetem Kontaktmaterial zwischen ein metallisches Steckergehäuse 2 und eine Gehäusewand 3 eines elektrischen Gerätes eingelegt. In das Steckergehäuse 2 ist eine strichpunktiert angedeutete Steckeinrichtung 4 eingesetzt, die mit einer an der Gehäusewand 3 befestigten Gegensteckeinrichtung 5 kontaktierbar ist. Die metallische Gehäusewand 3 weist im Steckerbereich eine Ausnehmung 6 auf, die sich mit einem Durchbruch 7 des Federblechs 1 deckt. Die Außenabmessungen des Federblechs 1 stimmen mit den Außenabmessungen des Steckergehäuses 2 überein. Die Gehäusewand 3 ist mit ausgeprägten Fixierzapfen 8 versehen, die in Fixierlöcher 9 des Federblechs hineinragen. Das Federblech 1 und die Gegensteckeinrichtung 5 sind mittels Gewindebolzen 13 an der Gehäusewand 3 befestigt. Halteschrauben 10 sind in die Gewindebolzen 13 einschraubbar und drücken das Steckergehäuse 2 gegen die Gehäusewand 3.

Das Federblech 1 weist entlang seiner Außenränder freiragende Zungen 11 auf, die durch kammartige Schlitze voneinander getrennt sind. Die Zungen 11 sind an ihren freien Enden um ihre Längsachse verdreht und bilden dadurch nach beiden Seiten kontaktgebende Erhebungen, die sich scharfkantig in die Oberflächen der Gehäusewand 3 bzw. des Steckergehäuses 2 eindrücken. Dabei wechselt die Drehrichtung von Zungen zu Zunge, was die Fertigung vereinfacht und die auftretenden Reibungskräfte kompensiert. Entlang dem Durchbruch 7 sind aus dem Federblech 1 Versteifungsstege 12 hochgebogen, die in die Ausdehnung 6 der Gehäusewand 3 hineinragen und das Federblech 1 stabilisieren.

## Patentansprüche

1. Federblech (1) zum elektrischen Kontaktieren zweier großflächig gegeneinander verspannter Gehäuseteile, wobei sich das Federblech (1) über den Kontaktierbereich erstreckt und zwischen die Gehäuseteile einlegbar ist und beidseitig eine Vielzahl von federnd nachgiebigen kontaktgebenden Erhebungen aufweist, wobei das Federblech (1) mit einer Vielzahl von freigeschnittenen Zungen (11) versehen ist, die nach beiden Seiten ausgebogene Abschnitte aufweisen, die die kontaktgebenden Erhebungen bilden, wobei die Zungen (11) so verformt sind, daß ihre höchsten Stellen in ihrem Kantenbereich liegen und wobei die Zungen (11) kammartig aneinander gereiht angeordnet sind,
**dadurch gekennzeichnet,**
daß die Zungen (11) um ihre Längsachse abwechselnd in entgegengesetzter Richtung verdreht sind.

2. Federblech nach Anspruch 1,
**dadurch gekennzeichnet,**
daß das Federblech (1) zwischen einem metallischen Steckergehäuse (2) einer Steckeinrichtung (4) und einer Gegensteckeinrichtung (5) zugeordeten metallischen Gehäuseteilen einlegbar ist, daß das Federblech (1) im Steckerbereich einen Durchbruch (7) aufweist und daß entlang dem Durchbruch (7) aus dem Federblech Versteifungsstege (12) hochgebogen sind.

3. Federblech nach Anspruch 2,
**dadurch gekennzeichnet**,
daß das Federblech (1) mittels Halteschrauben (10) an dem der Gegensteckeinrichtung (5) zugeordneten Gehäuseteil befestigbar ist und daß dieses fixierzapfen (8) aufweist, die in entsprechend angeordnete Fixierlöcher (9) des Federblechs (1) hineinragen.

## Claims

1. Spring plate (1) for electrically making contact between two housing parts mutually clamped together over a large area, the spring plate (1) extending over the contacting region and being able to be inserted between the housing parts and having on both sides a multiplicity of springy resilient contact-making elevations, the spring plate (1) being provided with a multiplicity of tongues (11) which are cut free and which have sections which are bent outwards towards the two sides and form the contact-making elevations, the tongues (11) being deformed in such a manner that their highest points are in an edge region and the tongues (11) being arranged lined up next to one another in the manner of a comb, characterized in that the tongues (11) are twisted about their longitudinal axis alternately in opposite directions.

2. Spring plate according to Claim 1, characterized in that the spring plate (1) can be inserted between a metallic plug housing (2) of a connector device (4) and metallic housing parts assigned to a mating connector device (5), in that the spring plate (1) has, in the plug region, a perforation (7) and in that reinforcing webs (12) are bent upwards from the spring plate along the perforation (7).

3. Spring plate according to Claim 2, characterized in that the spring plate (1) can be secured on the housing part assigned to the mating connector device (5) by means of holding screws (10) and in that this housing part has fixing pegs (8) which project into fixing holes (9), which are arranged correspondingly, in the spring plate (1).

## Revendications

1. Tôle élastique (1) destiné à établir le contact électrique entre deux parties de boîtier serrées l'une contre l'autre sur une grande surface, la tôle élastique (1) s'étendant sur la zone de contact, pouvant être insérée entre les parties du boîtier et comportant, des deux côtés, une multiplicité de parties surélevées flexibles élastiquement, qui établissent le contact, la tôle élastique à ressort (1) comportant une multiplicité de languettes découpées (11), qui comportent des tronçons coudés vers les deux côtés et formant les parties surélevées établissant le contact, les languettes (11) étant déformées de telle sorte que leurs points culminants soient dans la zone de leurs bords, et les languettes (1) étant disposées en rang l'une à la suite de l'autre à la manière d'un peigne, caractérisé par le fait que les languettes (11) sont inclinées en alternance en sens opposés, par rapport à leur axe longitudinal.

2. Tôle élastique suivant la revendication 1, caractérisé par le fait que la tôle élastique (1) peut être insérée entre un boîtier métallique (2) d'un dispositif d'enfichage (4) et des parties métalliques de boîtier, associées à un dispositif d'enfichage antagoniste (5), la tôle élastique à ressort (1) comporte un trou (7) dans la zone d'enfichage et que des barrettes de renforcement (12), issues de la tôle élastique sont coudées vers le haut le long du trou (7).

3. Tôle élastique suivant la revendication 2, caractérisé par le fait que la tôle élastique (1) peut être fixée au moyen de vis de fixation (10) à la partie du boîtier, qui est associée au dispositif d'enfichage antagoniste (5) et cette partie comporte des tétons de fixation (8), qui s'engagent dans des trous de fixation (9), disposés de façon correspondante, de la tôle élastique (1).
